# EUROPEAN PATENT SPECIFICATION

(11) **EP 3 220 430 B1**
(45) Date of publication and mention of the grant of the patent: **30.10.2019**
(21) Application number: 16160657.9
(22) Date of filing: 16.03.2016
(51) Int. Cl.: H01L 41/187, H01L 41/318

(54) **A PIEZOELECTRIC THIN FILM ELEMENT**
PIEZOELEKTRISCHES DÜNNSCHICHTELEMENT
ÉLÉMENT À FILM MINCE PIÉZOÉLECTRIQUE

(43) Date of publication of application: 20.09.2017
(73) Proprietor: Xaar Technology Limited, Cambridge CB4 0XR (GB)
(72) Inventor: MARDILOVICH, Peter, Cambridge CB4 0XR (GB); KO, Song-Won, Cambridge CB4 0XR (GB); TROLIER-MCKINSTRY, Susan, University Park, PA 16802 (US); BORMAN, Trent, University Park, PA 16802 (US); ZHU, Wanlin, University Park, PA 16802 (US)
(74) Representative: Pitchford, James Edward

(56) References cited:
- WO-A1-2015/030064
- US-A1- 2002 094 372
- US-A1- 2009 246 360
- US-A1- 2013 002 767
- US-A1- 2014 267 509

## Description

The present disclosure is generally concerned with a piezoelectric thin film element suitable for use in actuators, sensors, energy-harvesting devices and in multilayer capacitors as well as a method of manufacturing the element.

The present disclosure is particularly, although not exclusively, concerned with a method for the manufacture of a piezoelectric thin film element suitable for use as an actuator for a droplet deposition head in droplet deposition apparatus, as well as with actuators including the element, droplet deposition heads including the actuator and droplet deposition apparatus including the droplet deposition heads.

A variety of alternative fluids may be deposited by a droplet deposition head. For instance, a droplet deposition head may eject droplets of ink that may travel to a sheet of paper or card, or to other receiving media, such as ceramic tiling or shaped articles (for example, cans, bottles etc) to form an image, as is the case in inkjet printing applications (where the droplet deposition head may be an inkjet printhead or, more particularly, a drop-on-demand inkjet printhead.

Alternatively, droplets of fluids may be used to build structures, for example, electrically active fluids may be deposited onto receiving media such as a circuit board so as to enable prototyping of electrical devices.

In another example, polymer containing fluids or molten polymer may be deposited in successive layers so as to produce a prototype model of an object (as in 3D printing).

In still other applications, droplet deposition heads might be adapted to deposit droplets of solution containing biological or chemical material onto a receiving medium such as a microarray.

Droplet deposition heads suitable for such alternative fluids may be generally similar in construction to printheads with some adaptations made to handle the specific fluid in question.

Droplet deposition heads may be drop-on-demand droplet deposition heads wherein the pattern of droplets ejected varies in dependence on the input data provided to the head.

A typical piezoelectric thin film element suitable for use as an actuator for a droplet deposition head comprises a metal or metal oxide bottom electrode formed on a silicon or other substrate, a metal top electrode and a piezoelectric thin film interposed between the electrodes.

The piezoelectric thin film may comprise a lead containing perovskite (ABO₃) such as lead zirconate titanate (PZT) and be formed by a variety of techniques including sputtering, physical vapour deposition (PVD), chemical vapour deposition (CVD), pulsed laser deposition (PLD), atomic layer deposition (ALD) and a chemical solution deposition. The most commonly employed technique, however, is a chemical solution deposition, such as sol-gel deposition.

In a chemical solution deposition, the piezoelectric thin film is formed as a laminate comprising a plurality of piezoelectric thin film layers which have been individually formed and annealed together.

A solution is first deposited on to a bottom electrode (for example), dried and pyrolyzed to form a precursor layer for a first piezoelectric thin film layer. The precursor layer is then heat treated so that it anneals to form the first piezoelectric thin film layer as a crystalline thin film layer.

The solution is then applied to the first piezoelectric thin film layer, dried and pyrolyzed to form a precursor layer for the second piezoelectric thin film layer. The precursor layer is heat treated so that it anneals to form the second piezoelectric thin film as a crystalline thin film layer.

These latter steps are repeated so as to obtain a piezoelectric thin film on the bottom electrode comprising a laminate having a plurality of piezoelectric thin film layers and an appropriate thickness for the intended use of the piezoelectric element.

The chemical solution deposition may form multiple precursor layers by repeated application, drying and pyrolysis of a solution prior to a heat treatment in order to control the thickness of the piezoelectric thin film layer and the piezoelectric thin film. These thicknesses also depend on the overall solute concentration of the solution as well as other parameters such as the rate of spin coating of the solution.

Finally, a top electrode is formed on the piezoelectric thin film, for example, by sputtering a metal such as platinum, iridium or ruthenium and/or by reactive sputtering of metal oxide such as iridium dioxide.

The use of chemical solution deposition, and in particular sol-gel deposition, to form a piezoelectric thin film containing a lead-containing perovskite such as PZT is described in detail throughout the literature. One detailed description can be found, for example, in US patent application 2003/0076007 A1 (incorporated by reference herein).

Although a chemical solution deposition is more convenient as compared to other deposition techniques and offers greater flexibility for the control of the electrical and mechanical properties of the piezoelectric thin film, the extent of such control is limited by the number of different solutions which can be practically employed.

In particular, the tools used in the deposition typically allow for deposition of only three (or sometimes four) different solutions.

A piezoelectric thin film providing superior performance of the piezoelectric element must simultaneously show high effective piezoelectric constant (d_{31,f}), low current leakage and high breakdown voltage as well as controlled piezoceramic-electrode interfaces.

Such a piezoelectric thin film requires the deposition of at least five or six different solutions and necessitates costly modification of existing tools. This modification can also result in a tool which is overly complex and expensive to operate.

A method has now been found which enables the manufacture of a piezoelectric thin film comprising lead zirconate titanate (PZT) providing for superior performance in a piezoelectric element which requires no more than three different solutions and can employ conventional tools without modification.

US 6 080 499 discloses a ferroelectric capacitor comprising PZT layers having different lead composition. The PZT layers are sputtered using a lead rich target and a lesser lead rich target. A nucleation layer, and optionally a cap PZT layer are formed from the lead rich target and a bulk layer is formed from the lesser lead rich target.

US 2013/0002767 A1 discloses a study wherein six electromechanical transducer films are formed by laminating plural PZT thin films from pairs of sol-gel solutions having different lead content but the same Zr/Ti content. It is said here that the lead content of a transducer film is substantially homogenised in its thickness direction when the average Pb/(Zr+Ti) ratio is between 100 and 110% and the Pb/(Zr+Ti) ratio of interface PZT thin films differs from the average by up to 20%. It is also said that excellent transducing characteristics are obtained when the Zr/(Zr+Ti) ratio of interface PZT thin films differs from the average by up to 20%.

The present disclosure relates to a method which can provide a piezoelectric thin film element of superior performance as compared to the piezoelectric elements disclosed in US 6 080 499 and US 2013/0002767 A1.

Accordingly, in a first aspect, the present disclosure provides a method for the manufacture of a piezoelectric thin film element comprising a first electrode, a second electrode and one or more piezoelectric thin films there between which method comprises forming a piezoelectric thin film comprising PZT by a chemical solution deposition using three solutions wherein the forming of the PZT thin film comprises forming a bulk PZT thin film layer from the three solutions, wherein each solution has a Zr/Ti content which is different from that of any other solution and at least one solution has an excess lead content greater than that of any other solution, such that the bulk PZT thin film layer has a substantially uniform lead content and Zr/(Zr+Ti) ratio in its thickness direction.

Note that a reference herein to a bulk PZT thin film layer is a reference to a PZT thin film layer which alone or together with one or more similar PZT thin film layers forms the major part of the PZT thin film.

Note further that a reference to a chemical solution deposition includes a reference to a sol-gel deposition and that references to a solution include references to a sol-gel solution as well as a solution which does not develop a sol or gel during deposition. Such solutions differ only in the solubility of the selected precursor compounds and that the deposition steps for applying the solutions are substantially similar.

Note also that a bulk PZT thin film layer having a substantially uniform lead content and Zr/(Zr+Ti) ratio in the thickness direction of a PZT thin film layer is a bulk PZT thin film layer which is substantially free from gradient or has minimal gradient (for example, up to +/- 3% or 5% each) in lead content and Zr/(Zr+Ti) ratio in the thickness direction of that layer.

Each solution comprises a Zr/Ti content which is selected to take into account differing Zr and Ti ion diffusion occurring during the formation of the bulk PZT thin film layer by annealing the three precursor layers.

Each solution also comprises an excess lead content which is selected to take into account lead evaporation and diffusion occurring during the formation of the bulk PZT thin film layer on another PZT thin film layer from the three precursor layers.

In one embodiment, the method comprises forming the bulk PZT thin film layer by forming a first precursor layer from a first solution, a second precursor layer, on the first precursor layer, from a second solution and a third precursor layer, on the second precursor layer, from a third solution wherein the first solution has a Zr/Ti content higher than the second solution and the third solution has a Zr/Ti content lower than the second solution and wherein the second or third solution has an excess lead content which is greater than that of any other solution.

The excess lead content of the second or third solution may otherwise be selected so that one or more precursor layers formed from the second or third solution forms a PZT thin film layer on an electrode. This selection takes into account lead depletion and evaporation occurring during formation of a PZT thin film layer on an electrode. In particular, the excess lead content of the second or third solution is greater than that of any other solution.

In one embodiment, the method further comprises forming a PZT thin film layer on the first electrode, and in particular, an orientation-controlling PZT thin film layer, from the second or the third solution.

The Zr/Ti content of the first solution may otherwise be selected so that one or more precursor layers formed from the solution forms a current leakage barrier PZT thin film layer (henceforth a barrier PZT thin film layer) and/or a PZT-electrode interface PZT thin film layer (henceforth an electrode interface PZT thin film layer).

Alternatively or additionally, the Zr/Ti content of the first solution and the second or third solution may otherwise be selected so that respective precursor layers formed from each solution form a barrier PZT thin film layer and/or an electrode interface PZT thin film layer.

In one embodiment, therefore, the method further comprises forming a barrier PZT thin film layer from the first solution or from the first and second or third solutions.

In another embodiment, the method further comprises forming an electrode interface PZT thin film layer from the first solution or from the first and second or third solutions.

Note that an electrode interface PZT thin film layer may also act as a barrier PZT thin film layer. Note also that where a single solution is used for forming a PZT thin film layer, the method may comprise forming one or more precursor layers from that solution.

Note further that a barrier PZT thin film layer may have the same or a different Zr/(Zr+Ti) ratio as compared to that of an electrode interface PZT thin film layer. The selection of the Zr/Ti content in the first and second solutions and the use of these solutions may also reflect whether a barrier PZT thin film layer is to be formed or whether an electrode interface PZT thin film layer is to be formed. The selection may further reflect the position at which the barrier PZT thin film layer is to be formed in a PZT thin film as well as beneficial imprint of the electrode interface PZT thin film layer on the second electrode (for example).

The forming of the barrier PZT thin film layer or the electrode interface PZT thin film layer from the first and second solutions may comprise forming a first precursor layer from the first solution and a second precursor layer on the first precursor layer from the second or third solution. In that case, the Zr/(Zr+Ti) ratio in the PZT thin film layer may be substantially uniform in its thickness direction.

However, it may alternatively comprise forming a first precursor layer from the second or third solution and a second precursor layer on the first precursor layer from the first solution. In that case, the Zr/(Zr+Ti) ratio increases in the PZT thin film layer in its thickness direction.

The method may provide for forming an orientation-controlling PZT thin film layer on the first electrode with a pseudo cubic {100} orientation greater than 90% (as determined for example, by a Lotgering Factor LF₁₀₀ > 0.90).

In this embodiment, the method may comprise forming the orientation-controlling PZT thin film layer on a platinum electrode so that it has a thickness between 30 nm and 150 nm. In that case, the orientation-controlling PZT thin film layer may have a pseudo cubic {100} orientation around 90% provided that the excess lead content of the second or third solution is at least 10 mol%. The formation of such an orientation-controlling PZT thin film layer is described in detail in EP 2 52 391 A2.

Preferably, however, the excess lead content in the second or third solution is selected so that it provides for forming the orientation-controlling PZT thin film layer on a platinum electrode which has been deposited at high temperature. The pseudo cubic {100} orientation in this PZT thin film layer is not dependent on the thickness of the layer but only on the excess lead content of the solution used to form it.

In that case, the excess lead content in the second or third solution will generally be higher than that used in the former case. The degree of pseudo cubic {100} orientation may also be greater and, in particular, 95% or 98% or even 100%. The thickness of the orientation controlling PZT thin film layer can be between 10 nm and 150 nm.

The high-temperature deposited platinum electrode may be deposited by sputtering at a temperature at or above 450°C, for example, 500°C or 600°C. It may have a grain size greater than 50 nm, for example, between 100 nm and 500 nm and a thickness between 10 nm and 200 nm. It may also have a preferred (111) orientation.

The formation of this platinum electrode and the formation of an orientation-controlling PZT thin film layer on it is described in detail in our co-pending application of even date (incorporated by reference herein).

In other embodiments, the first electrode may comprise any suitable material, for example, iridium, lanthanum nickelate (LaNiO₃, LNO), iridium oxide (IrO₂, IO), strontium ruthenate (SrRuO₃, SRO). It may also comprise platinum upon which one of the aforementioned oxides has been deposited.

Note also that an orientation-controlling PZT thin film layer formed on the first electrode directs similarly high pseudo cubic {100} orientation in overlying PZT thin film layers notwithstanding that the Zr/(Zr+Ti) ratio in those layers may be different.

In one embodiment, the selections are such that the Zr/Ti content of each solution provides for forming the bulk PZT thin film layer with a Zr/(Zr+Ti) ratio between about 0.40 and 0.60, for example, at or about the MPB value, and in particular, at or about 0.52. The MPB value is the value of the Zr/(Zr+Ti) ratio at the morphotrophic phase boundary between the tetragonal and rhombohedral phases of PZT. At this value (typically at or about 0.52), the piezoelectric performance reaches a maximum.

In one embodiment, the first solution may have a relatively low excess lead content and a Zr/Ti content providing a PZT thin film layer having a Zr/(Zr+Ti) ratio above that of the bulk PZT thin film layer, for example, 0.60.

The second solution may have a relatively high excess lead content and a Zr/Ti content providing a PZT thin film layer having a Zr/(Zr+Ti) ratio which is the same as that of the bulk PZT thin film layer, for example, 0.52.

The third solution may have a relatively low excess lead content and a Zr/Ti content providing a PZT thin film layer having a Zr/(Zr+Ti) ratio below that of the bulk PZT thin film layer, for example, 0.44.

In another embodiment, the first solution may have a relatively low excess lead content and a Zr/Ti content providing a PZT thin film layer having a Zr/(Zr+Ti) ratio above that of the bulk PZT thin film layer, for example, 0.60.

The second solution may have a relatively low excess lead content and a Zr/Ti content providing a PZT thin film layer having a Zr/(Zr+Ti) ratio which is the same as that of the bulk PZT thin film layer, for example, 0.52.

The third solution may have a relatively high excess lead content and a Zr/Ti content providing a PZT thin film layer having a Zr/(Zr+Ti) ratio below that of the bulk PZT thin film layer, for example, 0.44.

In these embodiments, the relatively low excess lead content of the first and third solutions or of the first and second solutions may be the same or different to one another.

Note that references here to a solution providing a PZT thin film layer are references to providing a PZT thin film layer when the solution is used alone.

Note also that Zr/(Zr+Ti) ratio provided by the second solution may correspond to the Zr/(Zr+Ti) ratio in the bulk PZT thin film layer whilst that provided by the third solution compensates for that provided by the first solution.

Note further that the Zr/Ti content of each of the second and third solutions is particularly suitable for forming an orientation-controlling PZT thin film layer on a high-temperature deposited platinum electrode because high pseudo cubic {100} orientation is favoured by titanium rich solutions.

The excess lead content in each solution may be selected so that the lead content in the bulk PZT thin film layer is approximately stoichiometric and the second or third solution provides for forming the orientation-controlling PZT thin film layer.

The relatively high excess lead content may be between 10 mol% and 40 mol%, in particular, between 10 mol% and 20 mol%, for example, 12 mol%, 14 mol%, 16 mol% or 18 mol%. The relatively low excess lead content may be lower than this by up to 10 mol%, for example by 5 mol% or 2 mol%.

Note that a reference to a PZT thin film layer includes a reference to a doped PZT thin film layer comprising one or more dopant ions A or B which nominally replace either Pb (A site) or Zr or Ti (B site) ions in a perovskite structure. The PZT thin film layer may, for example, comprise (Pb_{1-z}A_{z}) (ZrₓTi₁₋ₓ)O₃ or Pb[Zrₓ(Ti₁₋ₓ)]_{1-y}B_{y}O₃ where x is the Zr/(Ti+Zr) ratio mentioned above and y and z are less than or equal to 0.20.

The precise excess lead content and Zr/Ti content in each solution will depend on the presence or not of a dopant as well as nature of the electrode on which the orientation-controlling PZT thin film layer is formed. The MPB value may vary depending on whether or not one or more of a dopant ion is present. The MPB value may, in particular, differ from 0.52 by, for example up to +/- 5% or higher, when one or more of a dopant ion is present.

Note also that a reference to mol% excess lead content in a solution is a reference to a number of moles of lead in the solution which exceeds the number of moles necessary for forming a PZT thin film layer with a stoichiometric amount of lead.

Thus, a reference to a solution comprising a 12 mol% excess lead content, for example, is a reference to a solution in which the number of moles of lead is 12% higher than the number of moles of lead required for a PZT thin film layer with stoichiometric amount of lead.

Such a solution may be written as Pb_{1.12}ZrₓTi₁₋ₓO₃ although it may actually provide a PZT thin film layer with an amount of lead slightly below or exceeding 1.00 (for example, by up to 5%) viz., comprising Pb_{∼1.00}ZrₓTi₁₋ₓO.

The amount of lead in a doped PZT thin film must sometimes exceed 1.00 in order that a perovskite structure is maintained. Consequently, the excess lead content of a solution including a dopant precursor compound may have an equal or higher mol% excess lead content as compared to that of a solution without the dopant precursor compound.

In some embodiments, each solution comprises one or more of a dopant precursor compound for doping of the PZT thin film layers by one or more of a donor, acceptor or isovalent dopant.

The three solutions may comprise the same dopant in the same concentration. However, they may also comprise different dopants and/or dopants at different concentration provided that the lead content and Zr/(Zr+Ti) ratio remain substantially uniform in the bulk PZT thin film layer.

The solutions may, in particular, each comprise up to 20 mol% of each dopant precursor compound, in particular, up to 15 mol%, for example, 10 mol%, 5 mol% or 2 mol%.

A donor dopant precursor compound may be selected to provide any one of the dopants of the group consisting of La³⁺, Ta⁵⁺, V⁵⁺, U⁵⁺, Nb⁵⁺ and W⁶⁺ as well as trivalent ions of the rare earth elements.

An acceptor precursor compound may be selected to provide any one of the dopants of the group consisting of Na⁺, K⁺, Cs⁺, Rb⁺, Cu⁺, Mn⁺, Li⁺, Cu²⁺, Co²⁺, Mn²⁺, Nb²⁺, Ni²⁺, Mn³⁺, Y³⁺, as well as divalent and trivalent ions of the alkaline earth and rare earth elements.

An isovalent precursor compound may be selected to provide any one of the dopants of the group consisting of Mn⁴⁺, Hf⁴⁺, Sn⁴⁺, Mg²⁺, Ca²⁺, Sr²⁺ and Ba²⁺ as well as other divalent ions of the alkaline earth and rare earth metals.

In one embodiment, the first solution comprises Pb_{1.14}Zr_{0.60}Ti_{0.40}, the second solution comprises Pb_{1.17}Zr_{0.52}Ti_{0.48} and the third solution comprises Pb_{1.14}Zr_{0.44}Ti_{0.55}. In another embodiment, the first solution comprises Pb_{1.14}Nb_{0.02}(Zr_{0.60}Ti0_{.40})O₃, the second solution comprises Pb_{1.17}Nb_{0.02}(Zr_{0.52}Ti_{0.48})O₃ and the third solution comprises Pb₁₁₄Nb_{0.02}(Zr_{0.44}Ti_{0.56})O₃.

In one embodiment, the method comprises forming the orientation-controlling PZT thin film layer on the first electrode and forming the bulk PZT thin film layer on the orientation-controlling PZT thin film layer. In this embodiment, the method may also comprise forming an electrode interface on the bulk PZT thin film layer.

In another embodiment, the method further comprises forming the orientation-controlling PZT thin film layer on the first electrode, and forming the barrier PZT thin film layer on the orientation-controlling thin film layer. In this embodiment the method comprises forming the bulk PZT thin film layer on the barrier PZT thin film layer. It may also comprise forming the electrode interface PZT thin film layer on the bulk PZT thin film layer.

The present disclosure also provides a method which comprises forming a plurality of bulk PZT thin film layers. The method may, in particular, comprise forming between two and fifteen, bulk PZT thin film layers, for example, three, four, five or six such layers.

The method may, in particular, comprise forming a plurality of PZT thin film layers and forming at least one of the barrier PZT thin film layer and the electrode interface PZT thin film layer.

In one embodiment, the method comprises forming a plurality of bulk PZT thin film layers on the orientation-controlling PZT thin film layer and forming an electrode interface PZT thin film layer on the bulk PZT thin film layers.

In another embodiment, the method comprises forming a plurality of PZT thin film layer on the orientation-controlling PZT thin film layer and forming a barrier PZT thin film layer wherein the barrier PZT thin film layer contacts two of the bulk PZT thin film layers. In this embodiment, the method may further comprise forming an electrode interface PZT thin film layer on the bulk PZT thin film layers.

The method may comprise forming the bulk PZT thin film layers and the barrier PZT thin film layer in any order although it is preferred that the barrier PZT thin film layer is located at or towards the centre of the bulk PZT thin film layers.

In still another embodiment, the method comprises forming a barrier PZT thin film layer on the orientation controlling PZT thin film layer and forming a plurality of bulk PZT thin film layers on the barrier PZT thin film layer. In this embodiment, the method may further comprise forming an electrode interface PZT thin film layer on the bulk PZT thin film layers.

The solution may, in particular, be made up from a commercially available sol-gel solution having a total weight concentration of soluble precursor compounds for PZT equal to or greater than 10 wt%. Suitable commercially available sol-gel solutions (Mitsubishi Materials) include 12 wt%, 15 wt% or 25 wt% sol-gel solutions.

The excess lead content of the commercial sol-gel solutions is 10 mol% and may be adjusted by adding a predetermined weight of the soluble lead precursor compound to a chosen extent. The Zr/Ti content may also be adjusted by adding a predetermined weight of one or other of the appropriate precursor compounds.

Note that where the first piezoelectric thin film layer is to be a doped PZT thin film layer, the dopant precursor compounds may simply be added to the commercial sol-gel solutions in the appropriate proportions.

Alternatively, the solutions may be made up from scratch to a suitable total weight concentration of precursor compounds for PZT (for example, 10 wt% or over) with a weight ratio of precursor compounds providing for a selected excess lead content and a selected ratio of titanium and zirconium precursor compounds.

The overall solute concentration of each solution may differ from, or be about the same as, that of any other of the solution so that the relative thicknesses of the PZT thin film layers may be the same or different. Of course, these thicknesses may be adjusted by selection of the rate and duration of spin coating of the solutions.

The method may comprise forming a second electrode on the piezoelectric thin film by any suitable technique. It may comprise in particular, sputtering platinum, iridium or ruthenium or reactive sputtering of a conductive metal oxide such as lanthanum niobate (LNO, LaNiO₃) or strontium ruthenate (SRO, SrRuO₃).

The method may further comprise forming the second electrode so that the piezoelectric thin film is interposed between the first and second electrodes. However, the method may also comprise forming the second electrode so that the first and second electrodes are provided on one surface of the piezoelectric thin film, for example, as an adjacent or interdigitated pair.

The forming of the precursor layers for each PZT thin film layer may employ any suitable technique and, in particular, spin or dip coating.

The forming of the PZT thin film layers may comprise drying, pyrolyzing and annealing or crystallising the precursor layers using heating and temperature protocols within conventional limits. The drying and pyrolysis may, in particular, be carried out in a single step.

The precise excess lead content of each of the solutions will depend to some extent on lead partial pressure (if a furnace is used) but the partial lead pressure in the furnace will also be within conventional limits.

For example, the drying may comprise heating spin coated layers to a temperature between 60°C and 250°C, in particular, between 100°C and 200°C for 2 or 3 minutes and the pyrolysis may comprise heating to a temperature of between 150°C and 500°C, in particular, between 200°C and 400°C, for example to 350°C for 1 to 10 minutes, and in particular, 5 minutes.

The annealing or crystallisation may comprise heating to a temperature between 550°C and 800°C, for example, between 600°C and 800°C and, in particular, 700°C. The annealing may be accomplished by a rapid thermal processing (RTP) of duration 30 to 300 seconds, in particular 60 seconds (with 2 SLPM O₂ flow) or by 15 minutes to 30 minutes in a furnace heated to the selected temperature.

In a second aspect, the present disclosure provides a piezoelectric thin film element comprising a first electrode, a second electrode and one or more piezoelectric thin films there between wherein a piezoelectric thin film adjacent the first electrode comprises a laminate comprising an orientation controlling PZT thin film layer contacting the first electrode, a bulk PZT thin film layer and, optionally, at least one of a barrier PZT thin film layer and an electrode interface PZT thin film layer wherein the bulk PZT thin film layer has a Zr/(Zr+Ti) ratio between about 0.40 and 0.60 and a lead content which are substantially uniform in the thickness direction of the layer.

In one embodiment, the bulk PZT thin film layer has a Zr/(Zr+Ti) ratio at or about the MPB value, for example, at or about 0.52.

The bulk PZT thin film layer may be formed from three precursor layers derived from respective solutions wherein each solution has a different Zr/Ti content and at least one solution has an excess lead content greater than that of any other solution.

The orientation-controlling PZT thin film layer may have a Zr/(Zr+Ti) ratio less than or equal to that of the bulk PZT thin film layer.

The orientation-controlling PZT thin film layer may, in particular, be formed from one of the three solutions so that the Zr/(Zr+Ti) ratio is also homogenous in its thickness direction.

The barrier PZT thin film layer and/or the electrode interface PZT thin film layer may have a Zr/(Zr+Ti) ratio greater than that of the bulk PZT thin film layer.

The barrier PZT thin film layer may be formed from one of the three solutions so that the Zr/(Zr+Ti) ratio is also substantially uniform in its thickness direction.

Alternatively, it may be formed from two precursor layers derived from respective solutions of the three solutions used for the bulk PZT thin film layer. The Zr/(Zr+Ti) ratio may be substantially uniform in the thickness direction of the barrier PZT thin film layer. In one embodiment, the ratio is uniform and as close to that of the bulk PZT thin film layer as is possible for a current leakage barrier layer.

The average of the Zr/(Zr+Ti) ratios in the orientation-controlling PZT thin film layer, the bulk PZT thin film layer and the barrier PZT thin film layer or the electrode interface PZT thin film layer may be equal to the Zr/(Zr+Ti) ratio in the bulk PZT thin film layer.

The first electrode may comprise any suitable material, for example, platinum, iridium, lanthanum nickelate (LaNiO₃, LNO), iridium oxide (IrO₂, IO), strontium ruthenate (SrRuO₃, SRO). It may also comprise platinum upon which one of the aforementioned oxides has been deposited.

The first electrode may, in particular, comprise a platinum electrode which has been deposited at a temperature above 450°C, for example, at 500°C or 600°C. This electrode may have a grain size greater than 50 nm, for example, 150 nm, 175 nm, 200 nm, 250 nm, 300 nm or 400 nm. The thickness of the electrode may be between 10 nm and 200 nm and it may also have a preferred (111) orientation.

In that case, the orientation controlling PZT thin film layer may have a pseudo cubic {100} orientation greater than 90%, for example, 95%, 98% or even 100%.

As mentioned above, where the first electrode comprises another material (for example, an ordinary platinum electrode), the orientation-controlling PZT may have a pseudo cubic {100} orientation around 90% when the layer is between 30 nm and 150 nm.

Note that the degree of orientation in all the PZT thin film layers may be greater than 90%, for example, 95% or higher (as determined for example, by a Lotgering Factor LF₁₀₀ > 0.90).

In one embodiment, the orientation-controlling PZT thin film layer is formed on the first electrode and the bulk PZT thin film layer is formed on the orientation-controlling PZT thin film layer. In this embodiment, an electrode interface PZT thin film layer may be formed on the bulk PZT thin film layer.

In another embodiment, the orientation-controlling PZT thin film layer is formed on the first electrode and the barrier PZT thin film layer is formed on the orientation-controlling PZT thin film layer. In this embodiment, the PZT thin film layer is formed on the barrier PZT thin film layer and an electrode interface PZT thin film layer may be formed on the bulk PZT thin film layer.

The laminate may comprise a plurality of bulk PZT thin film layers. It may, in particular, comprise between two and fifteen bulk PZT thin film layers, for example, three, four, five or six such layers.

In one embodiment, the laminate comprises a plurality of bulk PZT thin film layers formed on the orientation-controlling PZT thin film layer. In this embodiment, the laminate may further comprise an electrode interface PZT thin film layer formed on the bulk PZT thin film layers.

In another embodiment, the laminate comprises a plurality of bulk PZT thin film layers formed on the orientation-controlling PZT thin film layer and a barrier PZT thin film layer contacting two of the bulk PZT thin film layers. In this embodiment, the laminate may further comprise an electrode interface PZT thin film layer formed on a bulk PZT thin film layer.

Note that the laminate may comprise any order of bulk PZT thin film layers and a barrier PZT thin film layer. The barrier PZT thin film layer may, in particular, be located in or toward a central region of the bulk PZT thin film layers.

In still another embodiment, the laminate comprises a barrier PZT thin film layer formed on the orientation-controlling PZT thin film layer and a plurality of bulk PZT thin film layers formed on the barrier PZT thin film layer. In this embodiment, the laminate may further comprise an electrode interface PZT thin film layer formed on the bulk PZT thin film layers.

Note that in all embodiments, the PZT thin film layers may each have a pseudo cubic {100} orientation greater than 90%, for example, 95%, 98% or even 100% (as determined for example, by a Lotgering Factor LF₁₀₀ > 0.90) .

Note further that the PZT thin film layers may be doped by one or more of a donor, acceptor, or isovalent dopant. The extent of doping may be up to 20 mol% for each dopant, for example, 15 mol%, 10 mol%, 5 mol% or 2 mol%.

As mentioned above, a doped PZT thin film layer may, in particular, comprise (Pb_{1-z}A_{z})(ZrₓTi₁₋ₓ)O₃ or Pb[Zrₓ(Ti₁₋ₓ)]_{1-y}B_{y}O₃ where x is the Zr/(Ti+Zr) ratio mentioned above and y and z are less than or equal to 0.20. Further, the lead content may be non-stoichiometric to the extent that a perovskite structure is maintained - especially when a dopant ion is present.

A donor dopant may be selected from the group consisting of La³⁺, Ta⁵⁺, V⁵⁺, U⁵⁺, Nb⁵⁺ and W⁶⁺ as well as trivalent ions of the rare earth elements.

An acceptor dopant may be selected from the group consisting of Na⁺, K⁺, Cs⁺, Rb⁺, Cu⁺, Mn⁺, Li⁺, Cu²⁺, Co²⁺, Mn²⁺, Nb²⁺, Ni²⁺, Mn³⁺, Y³⁺, as well as divalent and trivalent ions of the alkaline earth and rare earth elements.

An isovalent dopant may be selected from the group consisting of Mn⁴⁺, Hf⁴⁺, Sn⁴⁺, Mg²⁺, Ca²⁺, Sr²⁺ and Ba²⁺ as well as other divalent ions of the alkaline earth and rare earth metals.

The PZT thin film layers may comprise the same dopant in the same concentration but they may also comprise different dopants or dopants at different concentration provided that the lead content and Zr/(Zr+Ti) ratio remains substantially uniform in each bulk PZT thin film layer.

The second electrode may comprise platinum, iridium or ruthenium or a conductive metal oxide such as lanthanum niobate (LNO, LaNiO₃) or strontium ruthenate (SRO, SrRuO₃).

In one embodiment, the second electrode is a top electrode and the piezoelectric thin film is interposed between the first and second electrodes.

In this embodiment, at least one additional piezoelectric thin film may be provided with at least one additional electrode so that the piezoelectric thin film element comprises a stack of alternate piezoelectric thin films interposed between electrodes.

The at least one additional piezoelectric thin film may be a PZT thin film and the additional electrodes may be high-temperature deposited platinum electrodes. The PZT thin film may be similar to that formed on the first electrode. It may, in particular, comprise PZT thin film layers, of similar lead content and Zr/(Zr+Ti) ratio, which may be similarly or differently doped.

The arrangements of the additional films and electrodes may otherwise be similar to those described in US provisional patent application No. 63/175,056 (incorporated by reference herein).

In another embodiment, the first and second electrodes are provided on one surface of the piezoelectric thin film, for example, as an adjacent or interdigitated pair.

Note that the first electrode may be formed on a substrate comprising any suitable material. The substrate may, for example, comprise a silicon crystal. The silicon crystal may be provided with an adhesion layer, for example, comprising one or more of titanium oxide, zinc oxide, indium oxide or gallium oxide, for facilitating the deposition of the platinum metal electrode. The silicon crystal may also be provided with a buffer layer (for example, silica) and/or a lead barrier layer (for example, alumina, hafnia or zirconia) which contacts the adhesion layer or the platinum electrode layer.

In a third aspect, the present disclosure provides a piezoelectric actuator comprising the piezoelectric element of the second aspect of the disclosure.

In a fourth aspect, the present disclosure provides a droplet deposition head comprising the piezoelectric actuator of the third aspect of the disclosure. The droplet deposition head may be a printhead for an inkjet printer and, in particular, a drop-on-demand printhead.

In a fifth aspect, the present disclosure provides a droplet deposition apparatus comprising the droplet deposition head of the fourth aspect of the disclosure.

In a sixth aspect, the present disclosure provides a solution comprising precursor compounds for lead zirconate titanate (PZT) in proportions providing a PZT thin film layer of composition at or about PbZrₓTi₁₋ₓO₃ where 0.40 ≤ x ≤ 0.60, and an excess lead content greater than 10 mol% and less than or equal to 40 mol%.

The solution may, in particular, comprise soluble precursor compounds for lead zirconate titanate (PZT) in proportions providing a PZT thin film layer of composition at or about the MPB value, for example, at or about PbZr_{0.52}Ti_{0.48}O₃ and an excess lead content between 12 mol% and 20 mol% and a dopant precursor compound up to 20 mol%.

Further embodiments in this aspect, will be apparent from the first and second aspects of the present disclosure.

Embodiments will now be described in more detail having regard to the following Example and the accompanying drawings in which:
Figure 1 is a scheme showing in cross-section view one embodiment of the method of the present disclosure;
Figures 2 and 3 show part section views of several piezoelectric thin film elements obtained by the method of the present disclosure; and
Figure 4 shows a part section view of one embodiment of a piezoelectric actuator according to the present disclosure.

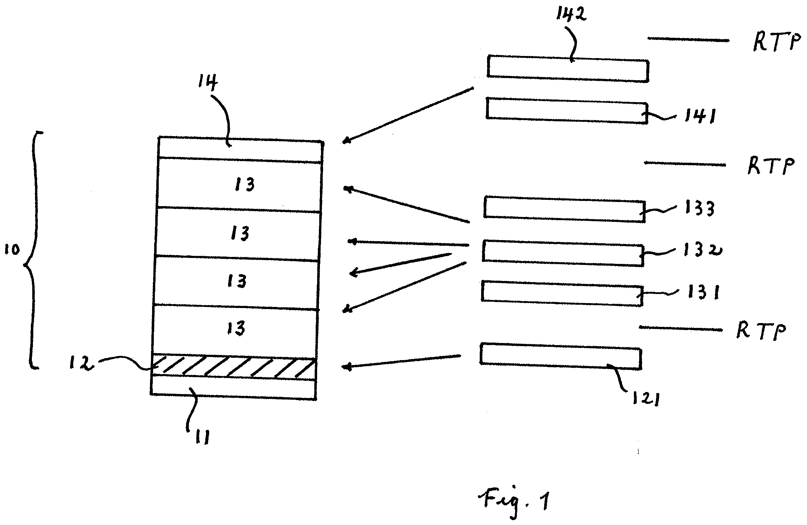

Referring now to Figure 1, one embodiment of the method of the present disclosure comprises forming a PZT thin film, generally designated as 10, on a platinum electrode 11 (cross hatched) deposited over a silicon substrate (not shown) at a temperature between 450°C and 1000°C (500°C for example) .

The method forms the PZT thin film as a laminate of PZT thin film layers by a sol-gel process using only three sol-gel solutions.

The first sol-gel solution is a zirconium rich solution, for example, Pb_{1.14}Nb_{0.02}(Zr_{0.60}Ti_{0.40})O₃, the second sol-gel solution is a lead rich solution, for example, Pb_{1.17}Nb_{0.02}(Zr_{0.52}Ti_{0.48})O₃ and the third sol-gel solution is a titanium rich solution, for example, Pb_{1.14}Nb_{0.02}(Zr_{0.44}Ti_{0.56})O₃. The overall solute content of these solutions is 15 wt%.

The method first forms an orientation controlling PZT thin film layer 12 on the platinum electrode from the second sol-gel solution (the lead rich solution). A single precursor layer 121 is formed by spin coating the second sol-gel solution (at 6000 rpm, for example), on to the electrode 11, drying and pyrolyzing the spin-coated layer (at 200°C for 2 or 3 minutes, for example) . The precursor layer 121 is then annealed at 700°C (for example, with 10°C/second temperature ramp, 60 seconds holding time and 2 SPLM O₂ flow).

The orientation-controlling PZT thin film layer 12 is substantially free from gradient in Zr/(Zr+Ti) ratio at 0.52 and has a pseudo cubic {100} orientation greater than or equal to 90%.

The method then forms a bulk PZT thin film layer 13 on the orientation-controlling PZT thin film layer 12 from the first, second and third sol-gel solutions. A first precursor layer 131 is formed on the orientation-controlling PZT thin film layer 12 from the first sol-gel solution (the zirconium rich solution), a second precursor layer 132 is formed on the first precursor layer 131 from the second sol-gel solution (the lead rich solution) and a third precursor layer 133 is formed on the second precursor layer 132 from the third sol-gel solution (the titanium rich solution).

The precursor layers 131 to 133 may be formed, for example, by spin coating each solution at 4000 rpm for 45 seconds, drying at 100°C for 1 minute and pyrolyzing at 300°C for 4 mins. The three precursor layers are annealed together at 700°C (for example, with 10°C/second temperature ramp, 60 seconds holding time and 2 SPLM O₂ flow).

The bulk PZT thin film layer 13 is substantially free from gradient (or has minimal gradient) in lead content and Zr/(Zr+Ti) ratio at 0.52 and also has a pseudo cubic {100} orientation greater than or equal to 90%.

The method repeats these steps so as to form four bulk PZT thin film layers 13 over the orientation-controlling PZT thin film layer 12. The four bulk PZT thin film layers 13 obtained are also substantially free from gradient (or have minimal gradient) in lead content and Zr/(Zr+Ti) ratio at 0.52 and have a pseudo cubic {100} orientation greater than or equal to 90%.

The method then forms a barrier PZT thin film layer 14 on the fourth bulk PZT thin film layer 13 from the first and second sol-gel solutions. A first precursor layer 141 is formed on the fourth bulk PZT thin film layer 13 from the first sol-gel solution (the zirconium rich solution) and a second precursor layer 142 is formed from the second sol-gel solution (the lead rich solution) on the first precursor layer 141.

The precursor layers 141 and 142 are formed and annealed together in the same way as for the bulk PZT thin film layer 13. The current leakage barrier layer 14 is substantially free from gradient in lead content and Zr/(Zr+Ti) ratio between 0.52 and 0.60 and also has a pseudo cubic {100} orientation greater than or equal to 90%.

The method then forms a top electrode (not shown) on the barrier PZT thin film layer by, for example, sputtering platinum, iridium or ruthenium or by reactive sputtering of iridium oxide, lanthanum niobate or strontium ruthenium oxide.

The piezoelectric response of PZT thin films formed in this way can be determined using a double beam laser interferometer (DBLI, from aixDBLI, Germany) with a positive voltage applied to the top electrode and the bottom electrode held at ground.

A PZT thin film having a single bulk PZT thin film layer formed on a PZT orientation-controlling layer and an electrode interface layer formed on the bulk PZT thin film layer (using only the first solution) showed effective piezoelectric constants d_{31,f} of at least 123 pm/V and e_{31,f} below -20 C/m² with a leakage current below 10⁻⁸ A/cm² when the element was driven by an electric field at 100 kV/cm.

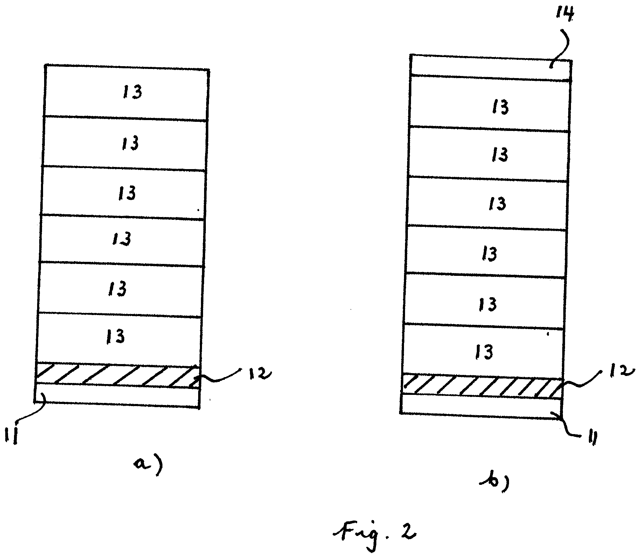

Figures 2 a) and b) show in part, two different embodiments of a piezoelectric thin film element according to the present disclosure. The piezoelectric elements are made by a similar method to that described above except that six bulk PZT thin film layers 13 are formed over the orientation controlling PZT thin film layer 12 with a barrier PZT thin film layer 14 and without a barrier PZT thin film layer 14.

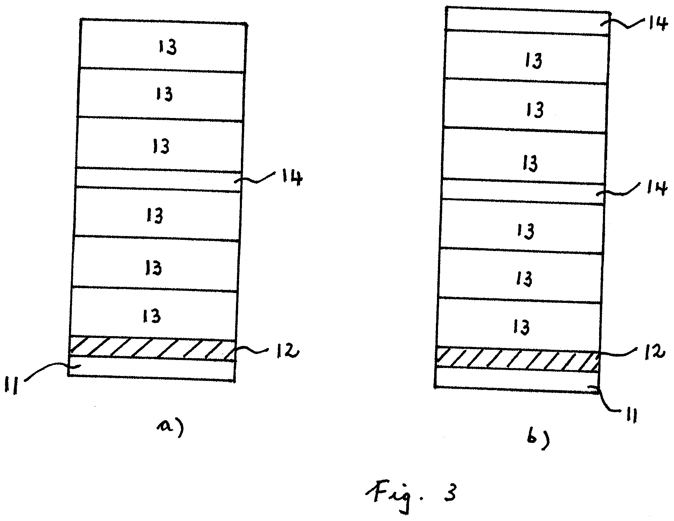

Figures 3 a) and b) show, in part two other embodiments of a piezoelectric element according to the present disclosure. The piezoelectric elements are made by a similar method to that described above except that the barrier PZT thin film layer 14 is provided after three bulk PZT thin film layers 13 have been formed over the orientation controlling PZT thin film layer 12.

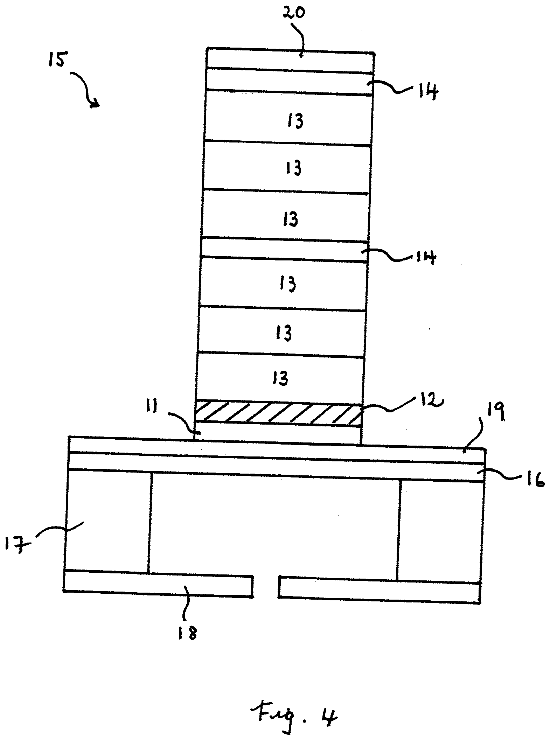

Figure 4 shows a part section view of an actuator (15) for a droplet deposition head according to one embodiment of the present disclosure. The piezoelectric thin film element of Figure 3 (b) is provided to a membrane (16) on top of a pressure chamber (17), provided with a nozzle plate (18).

The pressure chamber (17) may comprise a silicon single crystal of thickness about 70 µm and the membrane (16) may comprise a thin film comprising one or more of silicon oxide, zirconium oxide, tantalum oxide, silicon, silicon nitride, aluminium oxide and the like.

A titanium oxide adhesion layer (19) of thickness about 20 nm is interposed between the membrane (16) and the platinum metal electrode (11).

In use, a predetermined drive voltage is applied between the electrodes (11 and 20) by a signal from a control circuit. The voltage causes the piezoelectric thin film element to deform so deflecting the membrane (16) into the pressure chamber (17) and changing its volume. A sufficient increase in pressure within the pressure chamber (17) causes fluid droplets to be ejected from the nozzle in the nozzle plate (18).

The present disclosure provides a highly reliable piezoelectric element with high piezoelectric response and low current leakage by a chemical solution deposition forming an optimised PZT thin film using just three solutions.

The PZT thin film comprises PZT layers in composition and orientation addressing multiple requirements for optimum piezo and mechanical performance. The PZT thin film can comprise PZT thin film layers not only providing a current leakage barrier and an electrode interface layer but also PZT layers of composition at or around that of the morphotropic phase boundary which are substantially uniform in lead content and Zr/(Zr+Ti) ratio.

The PZT thin film may also include dopants to improve material properties (such as piezoelectric performance, reduced current leakage, optimised imprint or other properties, depending on the nature of the dopant or dopants). The absence of gradient in Zr/(Zr+Ti) ratio in the majority of PZT thin film layers enhances the piezoelectric performance of the material.

Note that the present disclosure necessarily refers in detail to a limited number of embodiments and that other embodiments which are not described here in detail are possible. For example, the embodiments described above may comprise an ordinary PZT thin film layer on the first electrode in place an orientation-controlling PZT thin film layer.

Note also that a reference to a particular range of values (for example, average grain size) includes the starting and finishing values.

Note further that it is the accompanying claims which particularly point out an invention in the present disclosure and the scope of protection which is sought.

## Claims

1. A method for the manufacture of a piezoelectric thin film element comprising a first electrode, a second electrode and one or more piezoelectric thin films there between which method comprises forming a piezoelectric thin film comprising PZT by a chemical solution deposition using three solutions wherein the forming of the PZT thin film comprises forming a bulk PZT thin film layer from the three solutions, wherein each solution has a Zr/Ti content which is different from that of any other solution and at least one solution has an excess lead content greater than that of any other solution, such that the bulk PZT thin film layer has a substantially uniform lead content and Zr/(Zr+Ti) ratio in its thickness direction.

2. A method according to Claim 1, wherein the forming of the bulk PZT thin film layer comprises forming a first precursor layer from a first solution, a second precursor layer on the first precursor layer from a second solution and a third precursor layer on the second precursor layer from a third solution wherein the first solution has a Zr/Ti content higher than the second solution and the third solution has a Zr/Ti content lower than the second solution.

3. A method according to Claim 2, wherein the excess lead content of the second or third solution is greater than that of any other solution.

4. A method according to Claim 2 or Claim 3, further comprising forming a barrier PZT thin film layer from the first solution or from the first and second or third solutions.

5. A method according to any of Claim 2 to Claim 4, further comprising forming an orientation-controlling PZT thin film layer on the first electrode from the second solution or the third solution.

6. A method according to Claim 4 or Claim 5, further comprising forming an electrode interface PZT thin film layer from the first solution or from the first and second or third solutions.

7. A method according to any preceding Claim, wherein the Zr/Ti content of each solution provides for forming the bulk PZT thin film layer with a Zr/(Zr+Ti) ratio between about 0.40 and 0.60.

8. A method according to any preceding Claim, wherein each solution comprises one or more of a dopant precursor compound providing for doping of the PZT thin film layers by one or more of a donor, acceptor or isovalent dopant.

9. A piezoelectric thin film element comprising a first electrode, a second electrode and one or more piezoelectric thin films there between wherein a piezoelectric thin film adjacent the first electrode comprises a laminate comprising an orientation controlling PZT thin film layer contacting the first electrode, a bulk PZT thin film layer and, optionally, at least one of a barrier PZT thin film layer and an electrode interface PZT thin film layer wherein the bulk PZT thin film layer has a Zr/(Zr+Ti) ratio between about 0.40 and 0.60 and a lead content which are substantially uniform in the thickness direction of the layer.

10. A piezoelectric thin film element according to Claim 9, wherein the orientation-controlling PZT thin film layer has a Zr/(Zr+Ti) ratio less than or equal to that of the bulk PZT thin film layer.

11. A piezoelectric thin film element according to Claims 9 or 10, wherein the barrier PZT thin film layer and/or the electrode interface PZT thin film layer has a Zr/(Zr+Ti) ratio greater than that of the bulk PZT thin film layer.

12. A piezoelectric thin film element according to any of Claims 9 to 11, wherein each PZT thin film layer has a pseudo cubic {100} orientation greater than 90%.

13. A piezoelectric thin film element according to any of Claims 9 to 12, wherein one or more of the PZT thin film layers is doped by one or more of a donor, acceptor or isovalent dopant.

14. A piezoelectric thin film element according to any of Claims 9 to 13, wherein each PZT thin film layer has substantially the same lead content.

15. A piezoelectric thin film element according to any of Claims 9 to 14, wherein the laminate comprises a plurality of bulk PZT thin film layers having a barrier PZT thin film layer there between.

## Patentansprüche

1. Verfahren zur Herstellung eines piezoelektrischen Dünnfilmelements, umfassend eine erste Elektrode, eine zweite Elektrode und einen oder mehrere piezoelektrische Dünnfilme dazwischen, wobei das Verfahren ein Ausbilden eines piezoelektrischen Dünnfilms, der PZT umfasst, durch eine chemische Lösungsabscheidung unter Verwendung von drei Lösungen umfasst, wobei das Ausbilden des PZT-Dünnfilms ein Ausbilden einer Massen-PZT-Dünnfilmschicht aus den drei Lösungen umfasst, wobei jede Lösung einen Zr/Ti-Gehalt aufweist, der sich von dem einer beliebigen anderen Lösung unterscheidet, und mindestens eine Lösung einen übermäßigen Bleigehalt aufweist, der höher als der einer beliebigen anderen Lösung ist, so dass die Massen-PZT-Dünnfilmschicht einen im Wesentlichen einheitlichen Bleigehalt und ein im Wesentlichen einheitliches Zr/(Zr+Ti)-Verhältnis in ihrer Dickenrichtung aufweist.

2. Verfahren nach Anspruch 1, wobei das Ausbilden der Massen-PZT-Dünnfilmschicht ein Ausbilden einer ersten Vorläuferschicht aus einer ersten Lösung, einer zweiten Vorläuferschicht auf der ersten Vorläuferschicht aus einer zweiten Lösung und einer dritten Vorläuferschicht auf der zweiten Vorläuferschicht aus einer dritten Lösung umfasst, wobei die erste Lösung einen Zr/Ti-Gehalt aufweist, der höher als die zweite Lösung ist, und die dritte Lösung einen Zr/Ti-Gehalt aufweist, der niedriger als die zweite Lösung ist.

3. Verfahren nach Anspruch 2, wobei der übermäßige Bleigehalt der zweiten oder der dritten Lösung höher als der einer beliebigen anderen Lösung ist.

4. Verfahren nach Anspruch 2 oder 3, weiterhin umfassend ein Ausbilden einer Barrieren-PZT-Dünnfilmschicht aus der ersten Lösung oder aus der ersten und der zweiten oder der dritten Lösung.

5. Verfahren nach einem der Ansprüche 2 bis 4, weiterhin umfassend ein Ausbilden einer die Ausrichtung steuernden PZT-Dünnfilmschicht auf der ersten Elektrode aus der zweiten Lösung oder der dritten Lösung.

6. Verfahren nach Anspruch 4 oder 5, weiterhin umfassend ein Ausbilden einer Elektrodengrenzflächen-PZT-Dünnfilmschicht aus der ersten Lösung oder aus der ersten und der zweiten oder der dritten Lösung.

7. Verfahren nach einem vorhergehenden Anspruch, wobei der Zr/Ti-Gehalt jeder Lösung ein Ausbilden der Massen-PZT-Dünnfilmschicht mit einem Zr/(Zr+Ti)-Verhältnis zwischen etwa 0,40 und 0,60 bereitstellt.

8. Verfahren nach einem vorhergehenden Anspruch, wobei jede Lösung eine oder mehrere von einer Dotierstoffvorläuferverbindung umfasst, die ein Dotieren der PZT-Dünnfilmschicht durch einen oder mehrere von einem Donator-, einem Akzeptor- oder einem isovalenten Dotierstoff bereitstellt.

9. Piezoelektrisches Dünnfilmelement, umfassend eine erste Elektrode, eine zweite Elektrode und einen oder mehrere piezoelektrische Dünnfilme dazwischen, wobei ein an die erste Elektrode angrenzender piezoelektrischer Dünnfilm ein Laminat umfasst, das eine die erste Elektrode berührende die Ausrichtung steuernde PZT-Dünnfilmschicht, eine Massen-PZT-Dünnfilmschicht und optional mindestens eine von einer Barrieren-PZT-Dünnfilmschicht und einer Elektrodengrenzflächen-PZT-Dünnfilmschicht umfasst, wobei die Massen-PZT-Dünnfilmschicht ein Zr/(Zr+Ti)-Verhältnis zwischen etwa 0,40 und 0,60 und einen Bleigehalt aufweist, die in der Dickenrichtung der Schicht im Wesentlichen einheitlich sind.

10. Piezoelektrisches Dünnfilmelement nach Anspruch 9, wobei die die Ausrichtung steuernde PZT-Dünnfilmschicht ein Zr/(Zr+Ti)-Verhältnis aufweist, das kleiner gleich dem der Massen-PZT-Dünnfilmschicht ist.

11. Piezoelektrisches Dünnfilmelement nach den Ansprüchen 9 oder 10, wobei die die Barrieren-PZT-Dünnfilmschicht und/oder die Elektrodengrenzflächen-PZT-Dünnfilmschicht ein Zr/(Zr+Ti)-Verhältnis aufweisen, das größer als das der Massen-PZT-Dünnfilmschicht ist.

12. Piezoelektrisches Dünnfilmelement nach einem der Ansprüche 9 bis 11, wobei jede PZT-Dünnfilmschicht eine pseudokubische {100}-Ausrichtung von mehr als 90 % aufweist.

13. Piezoelektrisches Dünnfilmelement nach einem der Ansprüche 9 bis 12, wobei eine oder mehrere der PZT-Dünnfilmschichten durch einen oder mehrere von einem Donator-, einem Akzeptor- oder einem isovalenten Dotierstoff dotiert werden.

14. Piezoelektrisches Dünnfilmelement nach einem der Ansprüche 9 bis 13, wobei jede PZT-Dünnfilmschicht im Wesentlichen denselben Bleigehalt aufweist.

15. Piezoelektrisches Dünnfilmelement nach einem der Ansprüche 9 bis 14, wobei das Laminat eine Vielzahl von Massen-PZT-Dünnfilmschichten mit einer Barrieren-PZT-Dünnfilmschicht dazwischen umfasst.

## Revendications

1. Procédé de fabrication d'un élément à film mince piézoélectrique comprenant une première électrode, une deuxième électrode et un ou plusieurs films minces piézoélectriques disposés entre elles, ledit procédé comprenant la formation d'un film mince piézoélectrique comprenant du PZT par dépôt chimique en solution pour lequel on utilise trois solutions, dans lequel la formation du film mince comprenant du PZT comprend la formation d'une couche de base de film mince comprenant du PZT à partir des trois solutions, chaque solution ayant une teneur en Zr/Ti qui est différente de celle de toute autre solution et au moins une solution ayant une teneur en plomb excédentaire supérieure à celle de toute autre solution, de telle sorte que la couche de base de film mince comprenant du PZT ait une teneur en plomb et un rapport Zr/(Zr + Ti) sensiblement uniformes dans la direction de son épaisseur.

2. Procédé selon la revendication 1, dans lequel la formation de la couche de base de film mince comprenant du PZT comprend la formation d'une première couche de précurseur à partir d'une première solution, d'une deuxième couche de précurseur sur la première couche de précurseur à partir d'une deuxième solution, et d'une troisième couche de précurseur sur la deuxième couche de précurseur à partir d'une troisième solution, dans lequel la première solution a une teneur en Zr/Ti supérieure à celle de la deuxième solution et la troisième solution a une teneur en Zr/Ti inférieure à celle de la deuxième solution.

3. Procédé selon la revendication 2, dans lequel la teneur en plomb excédentaire de la deuxième ou de la troisième solution est supérieure à celle de toute autre solution.

4. Procédé selon la revendication 2 ou la revendication 3, comprenant en outre la formation d'une couche barrière de film mince comprenant du PZT à partir de la première solution ou à partir de la première et des deuxième ou troisième solutions.

5. Procédé selon l'une quelconque des revendications 2 à 4, comprenant en outre la formation d'une couche de contrôle d'orientation constituée d'un film mince comprenant du PZT sur la première électrode formée à partir de la deuxième solution ou de la troisième solution.

6. Procédé selon la revendication 4 ou la revendication 5, comprenant en outre la formation d'une couche d'interface d'électrodes constituée d'un film mince comprenant du PZT à partir de la première solution ou à partir de la première et des deuxième ou troisième solutions.

7. Procédé selon l'une quelconque des revendications précédentes, dans lequel la teneur en Zr/Ti de chaque solution permet une formation de la couche de base de film mince comprenant du PZT selon un rapport Zr/(Zr + Ti) d'environ 0,40 à 0,60.

8. Procédé selon l'une quelconque des revendications précédentes, dans lequel chaque solution comprend un ou plusieurs d'un composé de précurseur de dopant permettant un dopage des couches de film mince comprenant du PZT par un ou plusieurs d'un dopant donneur, accepteur ou isovalent.

9. Élément à film mince piézoélectrique comprenant une première électrode, une deuxième électrode et un ou plusieurs films minces piézoélectriques disposés entre elles, dans lequel un film mince piézoélectrique adjacent à la première électrode comprend un stratifié comprenant une couche de contrôle d'orientation constituée d'un film mince comprenant du PZT en contact avec la première électrode, une couche de base de film mince comprenant du PZT et, optionnellement, au moins l'une d'une couche barrière de film mince comprenant du PZT et d'une couche d'interface d'électrodes constituée d'un film mince comprenant du PZT, dans lequel la couche de base de film mince comprenant du PZT a un rapport Zr/(Zr + Ti) d'environ 0,40 à 0,60 et une teneur en plomb qui sont sensiblement uniformes dans la direction d'épaisseur de la couche.

10. Élément de film mince piézoélectrique selon la revendication 9, dans lequel la couche de contrôle d'orientation constituée d'un film mince comprenant du PZT a un rapport Zr/(Zr + Ti) inférieur ou égal à celui de la couche de base de film mince comprenant du PZT.

11. Élément de film mince piézoélectrique selon les revendications 9 ou 10, dans lequel la couche barrière de film mince comprenant du PZT et/ou la couche d'interface d'électrodes constituée d'un film mince comprenant du PZT ont un rapport Zr/(Zr + Ti) supérieur à celui de la couche de base de film mince comprenant du PZT.

12. Élément de film mince piézoélectrique selon l'une quelconque des revendications 9 à 11, dans lequel chaque couche de film mince comprenant du PZT a une orientation pseudo-cubique {100} supérieure à 90 %.

13. Élément de film mince piézoélectrique selon l'une quelconque des revendications 9 à 12, dans lequel une ou plusieurs des couches de film mince comprenant du PZT est dopée par un ou plusieurs d'un dopant donneur, accepteur ou isovalent.

14. Élément de film mince piézoélectrique selon l'une quelconque des revendications 9 à 13, dans lequel chaque couche de film mince comprenant du PZT a sensiblement le même teneur en plomb.

15. Élément de film mince piézoélectrique selon l'une quelconque des revendications 9 à 14, dans lequel le stratifié comprend une pluralité de couches de base de film mince comprenant du PZT entre lesquelles est disposée une couche barrière de film mince comprenant du PZT.
